Europäisches Patentamt

European Patent Office

Office européen des brevets

(11) Numéro de publication : **0 016 705**
**B1**

(12) **FASCICULE DE BREVET EUROPÉEN**

(45) Date de publication du fascicule du brevet :
22.06.83

(21) Numéro de dépôt : **80400362.2**

(22) Date de dépôt : **18.03.80**

(51) Int. Cl.³ : **H 03 G   3/20**

(54) **Tête à radiofréquence à dynamique autoadaptative et récepteur comportant une telle tête.**

(30) Priorité : **20.03.79 FR 7907012**

(43) Date de publication de la demande :
**01.10.80 Bulletin 80/20**

(45) Mention de la délivrance du brevet :
**22.06.83 Bulletin 83/25**

(84) Etats contractants désignés :
**DE GB IT NL SE**

(56) Documents cités :
**FR A 2 376 557**
**GB A 469 428**
**GB A 1 108 070**
**US A 3 457 514**

(73) Titulaire : **THOMSON-CSF**
**173, Boulevard Haussmann**
**F-75379 Paris Cedex 08 (FR)**

(72) Inventeur : **Menant, Christophe**
**"THOMSON-CSF" SCPI - 173, Bld Haussmann**
**F-7560 Paris Cedex 08 (FR)**

(74) Mandataire : **Turlèque, Clotilde et al**
**THOMSON-CSF SCPI 173, Bld Haussmann**
**F-75379 Paris Cedex 08 (FR)**

Jouve, 18, rue St-Denis, 75001 Paris, France

Tête à radiofréquence à dynamique autoadaptative et récepteur comportant une telle tête

La présente invention concerne les têtes à radiofréquence, du type équipant les récepteurs soumis à des signaux parasites de niveau très variable, et dont la dynamique est autoadaptative en fonction de ce niveau. Elle concerne aussi les récepteurs comportant de telles têtes qui seront appelées dans ce qui suit sous le vocable habituel de tête H.F.

La réception de signaux faibles dans un champ perturbateur intense créé, par exemple, par l'émetteur local d'une liaison duplex, nécessite des dispositions particulières dans les circuits d'amplification d'entrée des récepteurs afin d'éviter une modulation de leur gain au rythme de l'intensité de ce champ d'où résulte une baisse de sensibilité du récepteur, accompagnée de transmodulation, et de risques d'intermodulation.

Dans ce but, il est connu d'utiliser dans la tête H.F. un étage d'entrée linéaire pour des niveaux suffisamment élevés, mais ceci est obtenu aux prix d'une forte consommation et d'un facteur de bruit élevé quelque soit le niveau du signal reçu.

Il est également connu, lorsque la tête H.F. comporte un étage amplificateur, d'adapter son point de fonctionnement automatiquement au niveau des signaux reçus (voir par exemple la demande GB-A-1 108 070).

Cette solution permet d'optimaliser la consommation et le facteur de bruit de l'amplificateur en fonction du niveau reçu, mais ceci n'est rendu raisonnablement possible que dans une dynamique de niveau d'entrée insuffisante par rapport à la dynamique des niveaux effectivement reçus. De plus l'étage mélangeur, qui suit habituellement cet étage amplificateur, doit être prévu pour accepter des niveaux qui peuvent être élevés.

La présente invention a pour but de pallier ces divers inconvénients.

Selon l'invention, une tête H.F. de réception à dynamique autoadaptative comportant en série un atténuateur variable à commande électrique, un étage amplificateur ayant une entrée de polarisation, et un étage convertisseur de fréquence ayant un niveau d'oscillation locale commandable, et des moyens de détection du signal reçu dont la sortie est reliée à des moyens de commande, est caractérisée en ce que les moyens de commande fournissent :

— à l'amplificateur une tension de polarisation constante pour un niveau de signal détecté inférieur à un premier seuil correspondant au niveau maximal en régime linéaire de cet amplificateur, et croissante pour un niveau détecté compris entre ce premier seuil et un seuil déterminé par le niveau de saturation de l'amplificateur,

— à l'étage convertisseur un signal de commande de niveau d'oscillation locale constant pour un niveau de signal détecté inférieur à un deuxième seuil correspondant au niveau maximal en régime linéaire du convertisseur et croissant pour un niveau détecté compris entre ce deuxième seuil et un seuil déterminé par le niveau de saturation du convertisseur, les lois de variation de la tension de polarisation et de ce signal de commande étant telles que les niveaux de saturation soient atteints pour un même seuil de niveau détecté dit troisième seuil,

— et à l'atténuateur, un signal de commande d'atténuation constant et correspondant à une atténuation quasi nulle pour un niveau détecté inférieur au troisième seuil et croissant au-dessus de ce troisième seuil.

L'invention sera mieux comprise et d'autres caractéristiques apparaîtront à l'aide de la description ci-après et des dessins s'y rapportant sur lesquels :

la figure 1 est un schéma de principe d'un exemple de tête H.F. de réception selon l'invention ;

la figure 2 est un diagramme explicatif du fonctionnement de la figure 1 ;

la figure 3 est un exemple de réalisation d'un élément de la figure 1.

Une borne d'entrée 1 est connectée à travers un filtre passebande 2 à un atténuateur variable 4 ayant une entrée de commande 5 et à un générateur de signaux de commande 3, à travers un détecteur 23. Un amplificateur à dynamique autoadaptative 6, ayant une entrée de commande 7, a son entrée de signal 8 connectée à la sortie de l'atténuateur 4 et sa sortie 9 reliée, à travers un filtre passe-bande 11, à une entrée de signal 10 d'un convertisseur de fréquence 12 ayant une entrée de commande 13 et une sortie 14.

Ce convertisseur de fréquence 12 comporte un mélangeur 15, inséré entre son entrée 10 et sa sortie 14 et ayant une entrée de signal d'oscillation locale 16 connectée à un générateur 17 à travers un atténuateur variable 18. Ce dernier à une entrée de commande reliée à l'entrée de commande 13.

Le fonctionnement sera mieux compris à l'aide de la figure suivante.

Sur la figure 2, la courbe 21 représente la variation de l'amplitude $A_7$ de la tension de polarisation de l'amplificateur 6 appliquée à son entrée de commande 7 en fonction du niveau d'entrée N de signaux appliqués au générateur 3 à travers le détecteur 23. Cette amplitude a une valeur minimale $A_{71}$ pour les niveaux reçus inférieurs à un niveau $N_1$ auxquels correspondent, pour l'amplificateur 6, un facteur de bruit et une consommation minimaux. Pour des niveaux reçus croissants à partir du niveau $N_1$, l'amplitude $A_7$ de la tension de polarisation croît de manière à augmenter la dynamique de l'amplificateur d'une quantité juste suffisante pour que l'amplificateur garde une linéarité satisfaisante pour le niveau d'entrée correspondant et obtenir ainsi le meilleur compromis entre la linéarité et le facteur de bruit.

Bien entendu cet accroissement de polarisation a des limites technologiques et ce niveau de polarisation $A_{72}$ restera constant pour tout niveau reçu supérieur à une valeur $N_A$.

La courbe 23 représente, en fonction de ce même niveau d'entrée N, les variations de l'amplitude $A_5$ de la tension de commande appliquée à l'entrée 5 de l'atténuateur 4. Pour les niveaux reçus inférieurs à $N_A$, $A_5$ prend une valeur $A_{51}$ constante correspondant à une valeur d'atténuation quasiment nulle pour l'atténuateur 4. Pour les niveaux reçus supérieurs à $N_A$, l'amplitude de la tension $A_5$ croît linéairement en fonction du niveau d'entrée de manière à maintenir un niveau constant à l'entrée de l'amplificateur 6. L'amplitude $A_{52}$ correspond à la valeur maximale d'atténuation de l'atténuateur 4 à laquelle correspond le niveau maximal reçu $N_M$ qui représente la valeur limite de la dynamique de l'ensemble de la tête H.F.

La courbe 22 représente la variation de l'amplitude $A_{16}$ du courant d'oscillation locale transmis au mélangeur 15, variation liée à celle du coefficient d'atténuation de l'atténuateur 18. Elle commande la dynamique du mélangeur 15. Ce dernier contribue au facteur de bruit d'ensemble de la tête H.F., et, pour les niveaux reçus de valeur très faible, doit présenter un facteur de bruit minimal, ce qui a lieu normalement pour la valeur minimale $A_{161}$ du courant d'oscillation locale, donc une valeur maximale du coefficient d'atténuation de l'atténuateur 18.

Soit $N_2$ le niveau reçu à partir duquel le mélangeur commence à être saturé, c'est-à-dire à perdre sa linéarité ; il est nécessaire, à partir de cette valeur, d'augmenter sa dynamique, c'est-à-dire en fait d'augmenter le courant d'oscillation locale et donc de réduire la valeur du coefficient d'atténuation de l'atténuateur 18, en fonction du niveau reçu N.

Le courant $A_{16}$ devra donc augmenter jusqu'à atteindre, pour un niveau reçu $N_A$, la valeur $A_{162}$ qui sera alors maintenue constante à partir de ce niveau reçu $N_A$, puisque l'atténuateur 4 se chargera, du moins jusqu'au niveau reçu $N_M$, de lui maintenir un niveau constant à l'entrée.

La figure suivante donne un exemple de réalisation du convertisseur de fréquence 12.

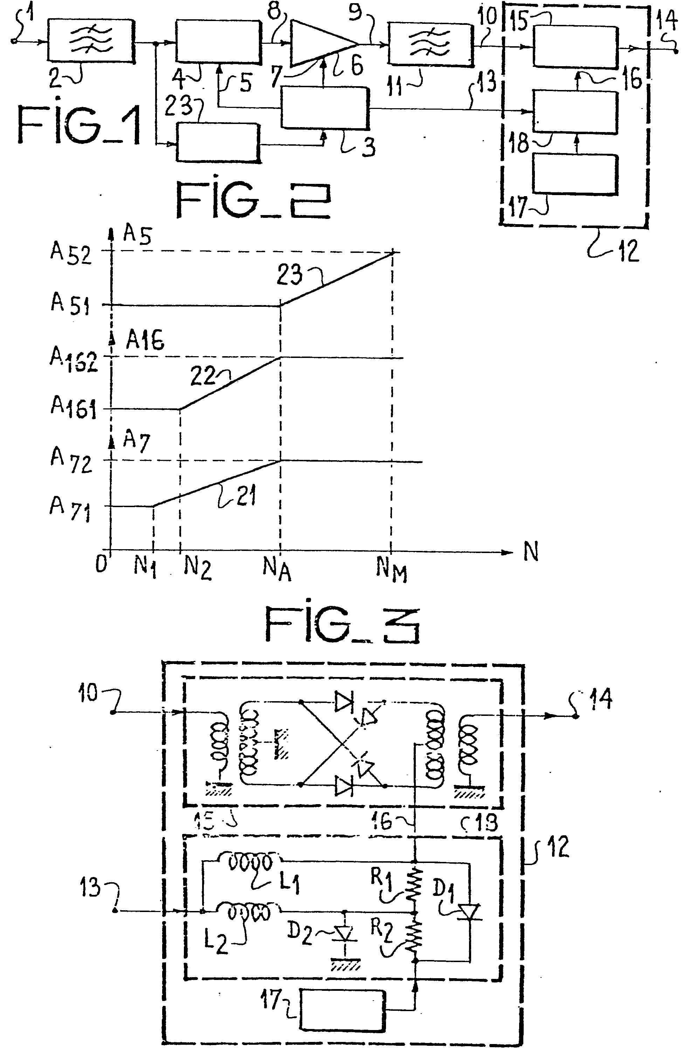

Sur la figure 3, où les repères identiques à ceux de la figure 1 désignent les mêmes organes, le mélangeur 15 est représenté sous la forme d'un modulateur en anneau classique à quatre diodes dont l'entrée 16 est celle de la tension de commutation, le signal incident étant appliqué sur l'entrée 10. Cette entrée 16 reçoit le courant fourni en sortie de l'oscillateur local 17 à travers l'atténuateur 18 en Té ponté constitué d'un ensemble de deux résistances en série de même valeur, $R_1$ et $R_2$, en parallèle avec une première diode à résistance variable $D_1$ dont l'anode et la cathode sont connectées respectivement aux extrémités libres de $R_1$ et $R_2$, et d'une deuxième diode à résistance variable $D_2$ dont la cathode est reliée à la masse et l'anode au point commun des résistances $R_1$ et $R_2$. L'entrée de commande 13 est connectée aux anodes des diodes $D_1$ et $D_2$ à travers les selfs inductances de blocage respectives $L_1$ et $L_2$.

Pour une tension nulle appliquée aux diodes par l'entrée 13 ces dernières présentent une résistance élevée, et l'atténuateur présente un coefficient d'atténuation maximal correspondant au courant d'oscillation locale $A_{161}$ permettant l'obtention d'un facteur de bruit minimal du mélangeur qui restera linéaire pour les niveaux reçus au plus égaux à $N_2$.

Pour des niveaux reçus croissants, la tension de commande de l'atténuateur 18 croîtra également, diminuant la résistance des diodes $D_1$ et $D_2$, donc le coefficient d'atténuation, ce qui entraîne une augmentation du niveau d'oscillation locale et par conséquent celle de la dynamique en rapport avec le niveau reçu accru qui l'a provoqué. Le courant $A_{16}$ cesse de croître lorsque le niveau reçu atteint la valeur $N_A$ à partir de laquelle l'atténuateur 4 rentre en action et à laquelle correspond la valeur $A_{162}$ du courant $A_{16}$.

Le principe de réalisation de l'atténuateur 18 peut être appliqué à l'atténuateur 4, avec toutefois une inversion du signe de la tension ou du branchement des diodes puisque l'atténuateur 4 doit présenter une atténuation croissante avec la tension de commande, à l'inverse de l'atténuateur 18.

Il apparaît ainsi clairement que la tête H.F. décrite, tout en présentant un facteur de bruit optimal pour les faibles niveaux reçus, garde une bonne linéarité dans une dynamique de niveau d'entrée importante, correspondant notamment à la présence de signaux parasites, et limite la dégradation du facteur de bruit au strict minimum correspondant à la dynamique nécessaire pour chaque valeur donnée de niveau d'entrée.

Bien entendu le mode de réalisation décrit est sujet à de nombreuses variantes.

En particulier, la variation du niveau d'oscillation locale appliqué au mélangeur 15 peut être obtenue par action directe sur l'oscillateur 17 ce qui aura pour effet de diminuer la consommation de ce dernier, ce qui peut présenter de l'intérêt dans le cas de matériel transporté où une faible consommation est recherchée.

La répartition de la sélectivité du récepteur entre les deux filtres de bande 2 et 11 n'a pas de rapport direct avec l'invention, ce partage est opéré de manière à obtenir le meilleur compromis à l'entrée de la tête H.F. entre le facteur de bruit et les produits d'intermodulation qui varient en sens inverse avec les performances du filtre. En effet, plus un filtre atténue hors bande, mieux il protège des intermodulations, mais plus il a de pertes d'insertion, donc il dégrade le facteur de bruit.

Dans l'exemple décrit, le détecteur 23 a son entrée connectée en sortie du filtre 2, le fonctionnement du dispositif reste inchangé si cette entrée est reliée à l'entrée 8 de l'amplificateur 6, à sa sortie 9 où à celle du filtre 11.

De même, la description suppose que l'amplificateur 6 se sature avant le mélangeur 15 ; bien entendu leurs points de saturation respectifs peuvent également être identiques, ou inversés, en fonction, notamment, du gain de l'amplificateur 6.

Enfin le dispositif est évidemment applicable aux têtes H.F. sans amplification d'entrée, aux fréquences très élevées notamment, où l'action du dispositif 3 se limite à commander la dynamique du mélangeur 15 et la valeur d'atténuation de l'atténuateur 4.

## Revendications

1. Tête H.F. de réception à dynamique autoadaptative comportant en série un atténuateur variable (4) à commande électrique, un étage amplificateur (6) ayant une entrée de polarisation, et un étage convertisseur de fréquence (12) ayant un niveau d'oscillation locale commandable, et des moyens de détection du signal reçu (23) dont la sortie est reliée à des moyens de commande (3), caractérisée en ce que les moyens de commande fournissent :

— à l'amplificateur (6) une tension de polarisation constante pour un niveau de signal détecté inférieur à un premier seuil ($N_1$) correspondant au niveau maximal en régime linéaire de cet amplificateur, et croissante pour un niveau détecté compris entre ce premier seuil ($N_1$) et un seuil déterminé par le niveau de saturation de l'amplificateur,

— à l'étage convertisseur (12) un signal de commande de niveau d'oscillation locale constant pour un niveau de signal détecté inférieur à un deuxième seuil ($N_2$) correspondant au niveau maximal en régime linéaire du convertisseur et croissant pour un niveau détecté compris entre ce deuxième seuil ($N_2$) et un seuil déterminé par le niveau de saturation du convertisseur, les lois de variation de la tension de polarisation et de ce signal de commande étant telles que les niveaux de saturation soient atteints pour un même seuil de niveau détecté dit troisième seuil,

— et à l'atténuateur (4), un signal de commande d'atténuation constant et correspondant à une atténuation quasi nulle pour un niveau détecté inférieur au troisième seuil ($N_A$) et croissant au-dessus de ce troisième seuil.

2. Tête H.F. selon la revendication 1, caractérisée en ce que l'étage convertisseur (12) est du type commutatif à quatre diodes auquel le signal d'oscillation locale est appliqué à travers un atténuateur variable supplémentaire (18) commandé électriquement, l'atténuateur (4) et l'atténuateur supplémentaire (18) comportant des diodes à résistance variable dont la valeur est commandée respectivement par le signal de commande d'atténuation et par le signal de commande de niveau d'oscillation locale.

3. Récepteur comportant une tête H.F. selon l'une des revendications précédentes.

## Claims

1. R.f. receiver front end with self-adaptive dynamic range comprising, in series, a variable electrically controlled attenuator (4), an amplifier stage (6) having a biasing input, and a frequency converter stage (12) having a controllable local oscillation level, and received signal detection means (23) the output of which is connected to control means (3), characterized in that the control means supply :

— to the amplifier (6) a biasing voltage which is constant for a detected signal level lower than a first threshold ($N_1$) corresponding to the maximum level for linear operation of this amplifier, and which increases for a detected level comprised between this first threshold ($N_1$) and a threshold determined by the saturation level of the amplifier,

— to the converter stage (12) a local oscillation level control signal which is constant for a detected signal level lower than a second threshold ($N_2$) corresponding to the maximum level for linear operation of the converter, and which increases for a detected level comprised between this second threshold ($N_2$) and a threshold determined by the saturation level of the converter, the variation functions of the biasing voltage and of this control signal being such that the saturation levels are reached at the same detected level threshold, termed third threshold,

— and to the attenuator (4) an attenuation control signal which is constant and corresponds to substantially zero attenuation for a detected level lower than the third threshold ($N_A$), and which increases above this third threshold.

2. R.f. front end in accordance with claim 1, characterized in that the converter stage (12) is of switching type having four diodes, to which the local oscillation signal is applied through an additional, electrically controlled variable attenuator (18), the attenuator (14) and the additional attenuator (18) comprising variable resistance diodes the values of which are controlled by the attenuation control signal and the local oscillation level control signal, respectively.

3. Receiver comprising a R.f. front end in accordance with any of the preceding claims.

## Ansprüche

1. HF-Empfänger-Eingangsschaltung mit selbstanpassender Dynamik und mit, in Reihenschaltung, einem elektrisch gesteuerten, variablen Dämpfungsglied (4), einer einen Polarisationseingang aufweisenden Verstärkerstufe (6) und einer Frequenzumsetzerstufe (12), die einen steuerbaren Lokaloszillatorpegel aufweist, sowie mit Detektionsmitteln (23) zur Detektion des empfangenen Signals, deren Ausgang mit den Steuermitteln (3) verbunden ist, dadurch gekennzeichnet, daß die Steuermittel liefern :

— zum Verstärker (6) eine Polarisationsspannung, die konstant ist für einen Pegel des erfaßten Signals, der niedriger ist als ein erster Schwellwert ($N_1$), der dem maximalen Pegel im linearen Betriebsbereich dieses Verstärkers entspricht, und zunimmt für einen erfaßten Pegel, der zwischen diesem ersten Schwellwert ($N_1$) und

einem Schwellwert liegt, der durch den Sättigungspegel des Verstärkers bestimmt ist,

— zur Umsetzerstufe (12) ein Lokaloszillatorpegel-Steuersignal, das konstant ist für einen Pegel des erfaßten Signals, der niedriger ist als ein zweiter Schwellwert ($N_2$), welcher dem maximalen Pegel im linearen Betriebsbereich des Umsetzers entspricht, und zunimmt für einen erfaßten Pegel, der zwischen diesem zweiten Schwellwert ($N_2$) und einem Schwellwert liegt, der durch den Sättigungspegel des Umsetzers bestimmt ist, wobei die Änderungsfunktionen der Polarisationsspannung und dieses Steuersignals derart sind, daß die Sättigungspegel für denselbem erfaßten Pegelschwellwert erreicht werden, der als dritter Schwellwert bezeichnet wird,

— und zu dem Dämpfungsglied (4) ein Dämpfungs-Steuersignal, das für einen erfaßten Pegel, der niedriger ist als der dritte Schwellwert ($N_A$), konstant ist und einer praktisch verschwindenden Dämpfung entspricht, und oberhalb dieses dritten Schwellwertes zunimmt.

2. HF-Eingangsschaltung nach Anspruch 1, dadurch gekennzeichnet, daß die Umsetzerstufe (12) vom Schaltertyp mit vier Dioden ist, an welche das Lokaloszillatorsignal über ein zusätzliches, elektrisch steuerbares variables Dämpfungsglied (18) angelegt ist, wobei das Dämpfungsglied (14) und das zusätzliche Dämpfungsglied (18) Dioden mit veränderlichem Widerstand enthalten, deren Wert durch das Dämpfungs-Steuersignal bzw. durch das Lokaloszillatorpegel-Steuersignal gesteuert wird.

3. Empfänger mit einer HF-Eingangsschaltung nach einem der vorstehenden Ansprüche.

FIG_1

FIG_2

FIG_3